# EUROPÄISCHE PATENTANMELDUNG

(11) **EP 2 088 223 A1**
(43) Veröffentlichungstag der Anmeldung: **12.08.2009**
(21) Anmeldenummer: 09150698.0
(22) Anmeldetag: 16.01.2009
(51) Int. Cl.: C23C 22/08, C23C 22/73, C23C 2/26, C23C 28/00, C25D 5/48, C23C 14/58

(54) **Phosphatiertes Stahlblech sowie Verfahren zur Herstellung eines solchen Blechs**

(30) Priorität: 16.01.2008 DE 102008004728
(71) Anmelder: ThyssenKrupp Steel AG, 47166 Duisburg (DE); Henkel AG & Co. KGaA, 40589 Düsseldorf (DE)
(72) Erfinder: Bause, Ralf, 44143, Dortmund (DE); Geruhn, Dieter, 59457, Werl (DE); Köhler, Stefan, Dr., 58239, Schwerte (DE); Schuhmacher, Bernd, Dr., 44227, Dortmund (DE); Schwerdt, Christian, Dipl.-Phys., 47051, Duisburg (DE); Wormuth, Reinhard, Dr., 44149, Dortmund (DE); Riemer, Monika, 86926, Greifenberg (DE); Riesop, Jörg, 50171, Kerpen (DE)
(74) Vertreter: Cohausz & Florack

(57) **Zusammenfassung**

Die vorliegende Erfindung betrifft ein Verfahren zum Herstellen eines Blechs aus Stahl für die Herstellung von Stahlbauteilen durch Umformen, insbesondere Tiefziehen, wobei das Blech mit einer Zink/Magnesiumschicht und einer auf dieser angeordneten Magnesium enthaltenden Phosphatschicht belegt ist, wobei folgende Schritte durchlaufen werden: Aufbringen einer Zink/Magnesiumschicht auf das Stahlblech, Aufbringen einer Phosphatierlösung auf das mit der Zink/Magnesiumschicht versehene Stahlblech. Darüber hinaus betrifft die vorliegende Erfindung ein Stahlblech für die Herstellung von Bauteilen durch Umformen, insbesondere Tiefziehen, belegt mit einer Zink/Magnesiumschicht und einer darauf angeordneten Magnesium enthaltenden Phosphatschicht.

## Beschreibung

Die Erfindung betrifft ein Blech aus einem Stahlwerkstoff, welches für die Herstellung von Stahlbauteilen durch Umformen, insbesondere Tiefziehen, bestimmt und mit einer Phosphatschicht belegt ist. Darüber hinaus betrifft die Erfindung ein Verfahren zur Herstellung eines solchen Stahlblechs.

Von im Karosseriebau verwendetem Stahlblech wird neben einer guten Umformeignung eine hohe Korrosionsbeständigkeit gefordert. Um letztere zu erfüllen, werden die Stahlbleche heute üblicherweise mit Zinküberzügen versehen, die den Stahlwerkstoff gegen einen unmittelbaren Kontakt mit der Umgebung schützen. Durch die Verzinkung können auch solche, an sich rostanfällige Stahllegierungen für die Herstellung langlebiger, gegen korrosive Angriffe unempfindlicher Automobilkarosserien verwendet werden, die sich durch eine besonders gute Umformeignung auszeichnen. Diese Stahlwerkstoffe ermöglichen es, komplex geformte, hoch belastbare Bauteile bei geringen Blechstärken zu formen. Aus derartigem Stahl hergestellte Karosseriebauteile lassen sich einfach weiter verarbeiten und besitzen am Ende der Lebensdauer des jeweiligen Fahrzeugs eine hervorragende Recyclingfähigkeit.

Die gute Schutzwirkung des Zinküberzuges und die in der Vergangenheit stetig gestiegene Wirtschaftlichkeit moderner Verzinkungsanlagen haben zu einer starken Zunahme der Verwendung verzinkter Stahlbleche im Automobilbau geführt. Der Zinküberzug wird dabei üblicherweise in Bandveredelungsanlagen aufgebracht. Dazu geeignet ist beispielsweise das Schmelztauchen (Feuerverzinken), bei dem das Stahlband eine Schmelze aus Zink oder Zinklegierungen durchläuft. Darüber hinaus lassen sich die Stahlbleche nach dem Tauchen in eine Zinkschmelze anschließend glühen, um einen Zink-Eisen Legierungsüberzug zu erhalten ("Galvannealing"). Die zinkbeschichtung kann auch elektrolytisch auf dem Stahlwerkstoff abgeschieden werden.

Neben dem Korrosionsschutz besteht eine speziell im Automobilkarosseriebau erhobene Forderung nach einer guten Lackiereignung der verarbeiteten Stahlbleche. Dies betrifft zum einen den Lackauftrag und zum anderen die Haftung des Lacks auf dem Blech. Um diese Anforderungen zu erfüllen, werden Feinbleche seit längerem schon vor dem Lackieren phosphatiert. Bei dieser Vorbehandlung wird die zu beschichtende Oberfläche des Stahlblechs in eine Phosphatierlösung getaucht oder mit Phosphatlösungen bespritzt. Kombinierte Verfahren zum Auftragen der Phosphatlösung sind ebenfalls bekannt.

Die Phosphatierlösungen können dabei neben den jeweils erforderlichen Gehalten an Phosphationen (PO₄) Zink-, Mangan- und Nickelionen enthalten. Derartige Zink-, Mangan- und Nickelionen enthaltende Phosphatierlösungen werden in der Fachsprache auch als "Trikation-Phosphatierlösung" bezeichnet (DE 197 56 735 A1).

Die EP 1 350 865 A2 beschreibt ein Verfahren zur Herstellung eines verzinkten Stahlblechs, das mit einer Phosphatschicht belegt ist und für deren Herstellung eine solche "Trikation-Phosphatierlösung" verwendet wird. Es wurde gefunden, dass sich Bleche mit einer dünnen Phosphatschicht besser als phosphatfreie Bleche in einem Umformwerkzeug umformen lassen. Gleichzeitig besitzen phosphatierte Bleche eine gute Lackiereignung.

Die unter Verwendung der oben genannten Phosphatierlösungen erhaltenen kristallinen Zinkphosphatschichten erfüllen die Ansprüche, die an eine Zinkphosphatierung gestellt werden, bereits sehr gut. Arbeitet man allerdings ohne Nickelionen, muss man Nachteile hinsichtlich Lackhaftung und Korrosionsschutz in Kauf nehmen.

Die Verwendung von Nickelionen in Phosphatierbädern ist jedoch heutzutage aus ökologischen und toxikologischen Gründen zunehmend unerwünscht. Darüber hinaus stellt Nickel einen außerordentlich teuren Badbestandteil dar und das Ablassen nickelhaltiger Abwässer ist unter Umweltschutzgesichtspunkten besonders aufwändig.

Aus der DE 197 40 935 A1 und der DE 39 20 296 A1 sind Verfahren zur Phosphatierung von verzinkten Stahlbändern bekannt, bei denen Nickel durch Magnesium ersetzt wird. Die oben genannten Probleme hinsichtlich Lackhaftung und Korrosionsschutz treten in diesem Fall nicht auf. Nachteilig an beiden Verfahren ist jedoch, dass für einen effektiven Einbau von Magnesium in die Phosphatschicht Phosphatierlösungen eingesetzt werden müssen, die einen hohen Gehalt an Magnesium aufweisen. So enthalten die Lösungen gemäß DE 197 40 935 A1 einen Gehalt an Magnesiumionen von mehr als 1 g/l und die Lösungen gemäß DE 39 20 296 A1 einen Magnesiumgehalt von mehr als 0,5 g/l. Ein solch hoher Anteil an Magnesiumionen ist aber nachteilig, da Stabilitätsprobleme hinsichtlich der Löslichkeit der Magnesiumionen auftreten. So werden üblicherweise zur Verbesserung der Beizwirkung komplexe und/oder freie Fluoride in der Phosphatierlösung eingesetzt, welche aber gelöste Magnesiumionen in Form von schwerlöslichem MgF₂ ausfällen. Aufgrund dieser Stabilitätsprobleme wird in der Phosphatierlösung vorhandenes Magnesium oftmals ausgefällt, anstatt in die Phosphatschicht eingebaut zu werden.

Die Aufgabe der Erfindung bestand daher darin, ein Verfahren zum Herstellen eines phosphatierten Stahlblechs für die Herstellung von Stahlbauteilen durch Umformen, insbesondere Tiefziehen, bereitzustellen, das die vorgenannten Probleme nicht aufweist.

Darüber hinaus soll ein für die Umformung zu einem Bauteil besonders geeignetes phosphatiertes Stahlblech bereit gestellt werden, welches insbesondere bereits bei einem Schichtgewicht der Phosphatschicht von 0,01 bis 3 g/m² einen hervorragenden Korrosionsschutz und gute Umformeigenschaften aufweist.

Diese Aufgabe wird in Bezug auf das Herstellungsverfahren durch ein Verfahren zum Herstellen eines Blechs aus Stahl für die Herstellung von Stahlbauteilen durch Umformen, insbesondere Tiefziehen, gelöst, wobei das Blech mit einer Zink/Magnesiumschicht und einer auf dieser angeordneten Magnesium enthaltenden Phosphatschicht belegt ist, und welches folgende Schritte umfasst:
- Aufbringen einer Zink/Magnesiumschicht auf das Stahlblech,
- Aufbringen einer Phosphatierlösung auf das mit der Zink/Magnesiumschicht versehene Stahlblech.

Das erfindungsgemäße Verfahren ermöglicht es gegenüber dem aus der EP 1 350 865 A2 bekannten Verfahren den Einsatz von Nickel zu reduzieren oder auch ganz auf dieses Metall zu verzichten, was aus ökologischer und ökonomischer Sicht wünschenswert ist.

Darüber hinaus muss im Unterschied zu den in der DE 197 40 935 A1 und der DE 39 20 296 A1 beschriebenen Verfahren das in die Phosphatschicht einzubringende Magnesium nicht in der Phosphatierlösung selbst enthalten sein, da es aus der Zink/Magnesiumschicht herausgelöst und in die Phosphatschicht eingebaut wird. Auf diese Weise kann in der Phosphatierlösung der Gehalt an Magnesium reduziert oder sogar ganz auf den Einsatz von Magnesium verzichtet werden. Dies ist deshalb vorteilhaft, weil wie oben dargelegt ein hoher Gehalt an Magnesiumionen in der Phosphatierlösung zu Stabilitätsproblemen führt.

Die Zink/Magnesiumschicht kann erfindungsgemäß noch weitere Elemente enthalten. Besonders gute Ergebnisse werden erzielt, wenn die Zink/Magnesiumschicht Aluminium, Chrom, Titan, Silicium und/oder Eisen enthält.

Vorzugsweise besteht die Zink/Magnesiumschicht entweder zum Teil oder ganz aus intermetallischen Mg-Zn Phasen. Die intermetallische Mg-Zn Phase, beispielsweise MgZn₂, kann in unterschiedlicher Anordnung vorliegen, beispielsweise als Schicht auf dem Zn-Überzug oder als Eutektikum auf den Korngrenzen der Zn-Mischkristalle.

Die Zink/Magnesiumschicht kann über verschiedene Verfahren auf dem Stahlsubstrat erzeugt werden. Wird ein mit einer Zink/Magnesiumschicht belegter Zinküberzug eingesetzt, hat es sich als erfindungsgemäß besonders geeignet erwiesen, das Stahlsubstrat zunächst zu verzinken und anschließend mit Magnesium zu versehen. Besonders gute Ergebnisse werden erzielt, wenn die hierbei gebildete Zink/Magnesiumschicht nach dem Aufbringen auf Temperaturen von 200°C bis 500°C erwärmt wird. Infolge der thermischen Behandlung bildet das Magnesium mit dem Zink die intermetallische Phase MgZn₂. Noch bevorzugter ist es aus energetischen Gesichtspunkten im Falle der Verfahrenskombination elektrolytisches Verzinken eines Stahlblechs und anschließendem Aufdampfen von Magnesium die Zinkschicht vor dem Aufbringen des Magnesiums zu erwärmen.

Der Erfolg der Erfindung ist unabhängig von der Art und Weise, wie die Zinkbeschichtung aufgebracht wird. So lässt sich bei erfindungsgemäßen Blechen der Zinküberzug elektrolytisch (vorzugsweise aus wässriger oder aprotischer Lösung), durch Schmelztauchen oder durch Aufdampfen, beispielsweise physikalische Gasphasenabscheidungsverfahren im Vakuum (PVD) aufbringen.

Die Magnesium- bzw. Zink-Magnesium Legierungsschicht auf dem Zinküberzug kann - unabhängig von dessen Art durch elektrolytische Abscheidung, Schmelztauchveredelung oder Vakuumbedampfung mit Zink - vorzugsweise mittels PVD-Verfahren aufgebracht werden. Auch eine Abscheidung durch elektrolytische Verfahren unter Verwendung von aprotischen Lösungen ist möglich. Ein solches Verfahren ist beispielsweise in DE 10 2004 037 673 A1 und in DE 102 57 737 B3 beschrieben.

Ebenso ist es möglich, die Zink/Magnesiumschicht auf dem Stahlblech allein durch Abscheidung aus der Schmelze oder ausschließlich durch Vakuumbedampfungsverfahren oder allein durch Abscheidung von Zink-Magnesium Legierungen aus aprotischen Elektrolyten, ggf. jeweils kombiniert mit anschließendem Glühen, zu erzeugen.

Wie bereits erwähnt ist es - möglicherweise wegen der Bildung einer intermetallischen Phase -besonders bevorzugt die Zink/Magnesiumschicht auf Temperaturen von 200°C bis 500°C, vorzugsweise 250 bis 400°C, insbesondere 320 bis 335°C zu erwärmen. Die Wärmebehandlung erfolgt hierbei vorzugsweise für einen Zeitraum von 1 Sekunde bis 3 Minuten, noch bevorzugter 5 bis 50 Sekunden. Geeignete Wärmeüberträger sind beispielsweise Elektronenstrahlen, Laser und/oder NIR (near infrared).

Erfindungsgemäß besonders geeignete Phosphatierlösungen sind Trikationen-Systeme. Solche Trikationen-Systeme sind im Handel erhältlich. Die Phosphatierlösung kann über jedes gängige Verfahren auf die Zink/Magnesiumschicht aufgebracht werden. Praktische Versuche haben jedoch gezeigt, dass sich besonders gute Beschichtungsergebnisse ergeben, wenn die Phosphatierlösung mittels Tauch-, Spritz- oder Roll-Coat-Verfahren (ohne Nachspülung) aufgebracht wird. Die Phosphatierlösung kann auch auf das zu beschichtende Stahlband aufgesprüht werden. Praktische Versuche haben ergeben, dass sich besonders gute Beschichtungsergebnisse ergeben, wenn der aufgebrachte Volumenstrom so bemessen ist, dass die zu beschichtende Oberfläche des Stahlbands vollständig mit Phosphatlösung gespült wird. Mit dem Roll Coat-Verfahren lassen sich besonders dünne Schichten erzielen.

Wie bereits oben erläutert, ist es auch günstig für die Gebrauchseigenschaften der erfindungsgemäß erzeugten Phosphatierung, wenn die Phosphatierlösung neben den gegebenenfalls vorhandenen Magnesiumionen zusätzliche Ni-, Mn- und/oder Zn-Ionen enthält. Bei Zugabe von Zn-, Mn- und Ni-Ionen zur für die Beschichtung verwendeten Phosphatlösung enthält die erhaltene Phosphatschicht Zink, Mangan und Nickel basiertes Hopeit. Der Gehalt an Mangan fördert dabei die Bildung kleiner, dicht gepackter Kristalle, die zu einer erhöhten Alkalibeständigkeit führen und so den Korrosionsschutz verbessern.

Werden die oben genannten Zn-, Mn- und Ni-Ionen enthaltenden Phosphatlösungen eingesetzt, so können handelsübliche Trikation-Phosphatiersysteme eingesetzt werden. Diese Vorgehensweise ist mit einem besonders niedrigen Aufwand verbunden. In diesem Fall entsteht ein in der Fachsprache "Quadro-Kationensystem" genanntes System (Mg, Ni, Mn, Zn), mit dem der Korrosionsschutz (auch der temporäre) gegenüber dem reinen Zink/Magnesiumüberzug und auch gegenüber handelsüblichen Zinkphosphatschichten nachhaltig verbessert werden kann.

Der Gehalt an Magnesium in der Phosphatierlösung beträgt vorzugsweise weniger als 0,5 g/l und insbesondere weniger als 0,1 g/l. Der Gehalt an Nickel in der Phosphatierlösung beträgt vorzugsweise weniger als 0,05 g/l, insbesondere weniger als 0,015 g/l.

Erfindungsgemäß bevorzugt ist der Einsatz von Lösungen mit nur geringen Magnesium- und Nickelgehalten bzw. von magnesium- und nickelfreien Lösungen. Auf die Verwendung von Magnesium in der Phosphatierlösung kann verzichtet werden, da dieses von der Zink/Magnesiumschicht bereitgestellt wird.

Der Magnesiumgehalt der Phosphatierlösung kann so gering gehalten werden, da die Zn-Mg Schicht durch den Beizangriff der Phosphatierlösung angelöst wird und somit herrscht an der Grenzfläche eine hohe Mg²⁺ Konzentration, was dann zu einem Einbau in die Phosphatschicht führt.

Wie bereits oben dargelegt, ermöglicht die vorliegende Erfindung durch den Einsatz von Magnesium in der Zink/Magnesiumschicht eine Reduzierung des Nickelgehalts der Phosphatierlösung, was aus ökonomischer und ökologischer Sicht von Vorteil ist.

Wird Mangan und/oder Zink eingesetzt, so beträgt der Mangangehalt in der Phosphatierlösung vorteilhafter Weise 1 bis 6 g/l, vorzugsweise 1,5 bis 4 g/l, insbesondere 1,8 bis 2,2 g/l und der Zinkgehalt 1 bis 7 g/l, vorzugsweise 2 bis 4,5 g/l und insbesondere 2,3 bis 2,7 g/l.

Die erfindungsgemäße Aufgabe wird ferner mit einem Blech aus Stahl für die Herstellung von Stahlbauteilen durch Umformen, insbesondere Tiefziehen, gelöst, welches mit einer Zink/Magnesiumschicht und einer darauf angeordneten Magnesium enthaltenden Phosphatschicht belegt ist. Das erfindungsgemäße Blech kann mit dem oben beschriebenen Verfahren hergestellt werden.

Besonders vorteilhaft an dem erfindungsgemäßen Blech ist, dass es überraschenderweise bereits bei so geringen Phosphat-Schichtgewichten wie 0,01 g/m² hervorragende Umformeigenschaften aufweist. Gemäß einer bevorzugten Ausführungsform weist die Magnesium enthaltende Phosphatschicht ein Schichtgewicht von lediglich 0,01 bis 3 g/m², vorzugsweise von 0,1 bis 1,8 g/m², und insbesondere von 0,7 bis 1 g/m² auf.

Ein weiterer Vorteil der mit dem erfindungsgemäßen Verfahren aufgebrachten Phosphatschicht besteht darin, dass bereits ab Schichtdicken von 0,8 g/m² eine geschlossene Phosphatschicht vorliegt, während bei der Verwendung konventioneller Trikation-Phosphatschichten erst bei höheren Auflagen eine geschlossene Phosphatschicht vorliegt. Diese schnelle Schließung der Phosphatschicht ist deshalb erwünscht, weil hierdurch Phosphatgewicht eingespart werden kann, was wiederum die Widerstands-Punktschweißeignung deutlich verbessert. Schließlich kann auf diese Weise auch die Produktionsgeschwindigkeit erhöht werden.

Besonders bevorzugt ist mithin ein erfindungsgemäßes Blech, in dem die Phosphatschicht ein Schichtgewicht von 0,8 bis 1,0 g/m² aufweist, da dieses einen guten Korrosionsschutz neben sehr guten Umformeigenschaften besitzt und dennoch gute Eigenschaften im Hinblick auf die Widerstands-Punktschweißeignung aufweist.

Die Bildung einer dünnen geschlossenen Phosphatschicht ist darüber hinaus deshalb von großem Vorteil, weil durch sie besonders gute Korrosionsschutz- und Umformeigenschaften erreicht werden können. Insbesondere wird auch ein hervorragender temporärer Korrosionsschutz geölter erfindungsgemäßer Bleche erzielt.

Das erfindungsgemäße Blech zeichnet sich ferner dadurch aus, dass die mittlere Kristallgröße der Phosphatschicht sehr gering ist. So zeigen Rasterelektronenmikroskopaufnahmen von Phosphatschichten erfindungsgemäßer Bleche, die "Quadrokationensysteme" (Mg, Ni, Mn und Zn) enthalten, typischerweise eine mittlere Kristallgröße der Phosphatschicht von 0,1 bis 5 µm, vorzugsweise 0,5 bis 4 und insbesondere 1 bis 3 µm, während Trikation-Zinkphosphatschichten üblicherweise mittlere Kristallgrößen von 1 bis 5 µm aufweisen. Durch diese geringen Kristallgrößen wird das Umformverhalten der erfindungsgemäßen Bleche begünstigt, da sich die spezifische Oberfläche vergrößert beziehungsweise feine Schmiertaschen zur Aufnahme und Abgabe von Schmiermittel zur Verfügung gestellt werden.

Die feine Kristallstruktur der Phosphatschicht wird erfindungsgemäß auf den Zink-Magnesium Überzug zurückgeführt, so dass sich die Phosphatschicht schneller, also bereits bei geringeren Auflagen als bei herkömmlichen Systemen schließt. Die feinere Phosphatkristallstruktur wird typischerweise bei Phosphatierung von mit einer Zink-Magnesium Schicht belegtem elektrolytisch verzinktem Stahlfeinblech (ZEMg) gefunden. Gründe dafür liegen in der feinen MgZn₂-Struktur, welche die feinere Keimbildung (gegenüber ZE) begünstigt. Ferner beschleunigt die Reaktionsfreudigkeit des Mg die Keimbildung und/oder das Keimwachstum. Möglich ist auch eine Kombination aus beiden Mechanismen.

Durch die feine Kristallstruktur kommt es ferner zu einer verbesserten Verzahnung mit Lacken. So erweisen sich Lacke, die auf den erfindungsgemäßen Blechen aufgebracht wurden, gegenüber herkömmlichen Blechen als besonders widerstandsfähig gegen Steinschlag. Darüber hinaus kann auch die Klebeignung (Belastbarkeit hochfester Strukturklebstoffe) durch die feineren Kristalle verbessert werden.

Wie oben erläutert, ist die Zink/Magnesiumschicht vorzugsweise gekennzeichnet durch eine MgZn₂-Phase, die auf dem Zinküberzug liegt. Ein mögliches Verfahren zur Herstellung eines derart aufgebauten erfindungsgemäßen Blechs besteht darin, auf ein verzinktes Stahlblech eine Magnesiumschicht aufzubringen, die thermisch einzulegieren und auf diesen Überzug dann eine Phosphatschicht aufzubringen. In diesem Verbundsystem kann, wie erfindungsgemäß beabsichtigt Magnesium aus dem Zink/Magnesiumübezug gelöst und in die Phosphatschicht eingebaut werden. Die Menge an Magnesium in der Magnesiumschicht kann folglich auch so gewählt werden, dass das gesamte in ihr vorhandene Magnesium von der Phosphatschicht aufgenommen wird. Auch diese Ausführungsform soll von dem erfindungsgemäßen Begriff Zink/Magnesiumüberzug umfasst sein. Vorzugsweise kann der Magnesiumgehalt der Magnesiumschicht so gewählt werden, dass dieser den Sättigungsgehalt der Phosphatschicht übersteigt. In diesem Fall verbleibt nach Auftragen der Phosphatschicht zwischen der Zinkschicht und der Magnesium enthaltenden Phosphatschicht ein Teil des ursprünglich vorhandenen Zink/Magnesiumüberzugs. Diese Ausführungsform ist vorteilhaft, da der Magnesiumgehalt der aufzubringenden Magnesiumschicht leichter eingestellt werden kann.

Ist die Zink/Magnesiumschicht dagegen eine Magnesium enthaltende Zinkschicht, beispielsweise in Form einer Zink/Magnesiumlegierung, verbleibt nach Aufbringen der Phosphatschicht entsprechend entweder eine Zinkschicht oder eine Zink/Magnesiumlegierung mit vermindertem Magnesiumgehalt oder Mg-verarmten Bereichen.

Der Magnesiumgehalt der Phosphatschicht hängt prinzipiell sowohl von dem Magnesiumgehalt der Zink/Magnesiumschicht als auch von der gegebenenfalls in der Phosphatierlösung enthaltenen Menge an Magnesium ab. Ab einem bestimmten Magnesiumgehalt in diesen beiden Magnesiumreservoiren stellt sich jedoch eine Sättigung ein. Vorzugsweise beträgt der Magnesiumgehalt in der Phosphatschicht 0,1 bis 5 Gew.%, vorzugsweise 0,5 bis 3 Gew.%, und insbesondere 1,3 bis 1,7 %.

Wie bereits oben dargelegt, besteht ein wesentlicher Vorteil des erfindungsgemäßen Blechs darin, dass die Phosphatschicht nickelfrei sein kann ohne dass dies negative Auswirkungen auf Lackhaftung und Korrosionsschutz hat. Dennoch kann die Phosphatschicht selbstverständlich Nickel enthalten. In diesem Fall beträgt der Nickelgehalt in der Phosphatschicht vorzugsweise weniger als 1,5 Gew.%, noch bevorzugter weniger als 1 Gew.% und insbesondere weniger als 0,8 Gew.%.

Gemäß einer bevorzugten Ausführungsform der Erfindung enthält die Phosphatschicht ferner Mangan und/oder Zink. In diesem Fall beträgt der Mangangehalt in der Phosphatschicht vorzugsweise 1 bis 8 Gew.%, vorzugsweise 3 bis 5 Gew.%. Der Zinkgehalt beträgt zusammen mit allen anderen Kationen vorzugsweise 38 bis 45, vorzugsweise 41 bis 43 Gew %

Das erfindungsgemäße Blech kann lediglich auf einer Seite mit der Zink/Magnesiumschicht und der darauf angeordneten Magnesium enthaltenden Phosphatschicht versehen sein. Vorzugsweise ist das erfindungsgemäße Blech jedoch auf Ober- und Unterseite mit mindestens einer dieser Schichten versehen.

Gemäß der Erfindung wird auf das zu verformende Stahlblech ein Zink/Magnesiumüberzug und auf diesen eine Phosphatlösung aufgetragen. Die hierbei gebildete Phosphatschicht weist vorzugsweise ein geringes Schichtgewicht auf. Beim Aufbringen der Phosphatschicht löst sich Magnesium aus der Zink/Magnesiumschicht und wird in die Phosphatschicht hinein eingebaut.

Überraschender Weise verleihen die dünnen Magnesium enthaltenden Phosphatschichten den erfindungsgemäßen Blechen verbesserte Korrosionsschutzeigenschaften. Darüber hinaus lassen sich die erfindungsgemäßen Bleche hervorragend in einem Umformwerkzeug verformen und also mit Blechen vergleichen, die in bekannter Weise mit größeren Phosphatschichtdicken belegt worden sind. So zeigt sich insbesondere bei Tiefziehoperationen mit hohen Umformgraden, dass sich bei Verwendung erfindungsgemäß beschichteter Bleche eine deutliche Reduzierung der Reibung zwischen Werkzeug und Blech einstellt. Diese Minderung der Reibung erlaubt es, solche Bleche, deren Umformeignung an sich wegen der bei konventioneller Vorgehensweise auftretenden Spannungen begrenzt ist, über diese Grenzen hinaus zu verformen. Auf diese Weise lässt sich der beispielsweise bei der Herstellung komplex geformter Bauteile entstehende Aufwand minimieren. Gleichzeitig besitzen erfindungsgemäß beschaffene Bleche eine hervorragende Lackiereignung, da die dünne, mit geringer Schichtdicke aufgetragene Phosphatschicht sich besonders gleichmäßig auf der Blechoberfläche bildet.

Das erfindungsgemäße Verfahren lässt sich besonders wirtschaftlich durchführen, indem die einzelnen Arbeitsschritte in einer Fertigungslinie durchgeführt werden. Bei einer solchen "in line" aufeinander folgenden Durchführung der verschiedenen Beschichtungsschritte steht beim Verlassen der Fertigungslinie bei hohem Durchsatz ein Produkt zur Verfügung, welches sich unmittelbar anschließend zu einem Blechbauteil umformen lässt.

Bevorzugterweise wird das erfindungsgemäß phosphatbeschichtete Band bereits in der Bandanlage vor seiner Verformung mit einem Öl besprüht, um die Reibung während des Verformungsvorgangs weiter zu vermindern. Durch die feine Kristallstruktur wird die Ölaufnahme für und Abgabe beim Abpressen erleichtert. Dies führt zu einem Vorteil beim Umformen.

Nachfolgend wird die Erfindung anhand zweier Ausführungsbeispiele näher erläutert.

### Ausführungsbeispiel 1

Ein handelsübliches Stahlband wird in bekannter Weise gebeizt und elektrolytisch verzinkt. Beim Verlassen der Verzinkungszellen weist das Stahlband eine entfettete einwandfrei wasserbenetzbare Oberfläche auf. Auf dieses verzinkte Blech wird eine Magnesiumschicht mit einer Dicke von 0,8 µm, mittels eines Jet-Verdampfers (PVD-Verfahren) aufgedampft. Eine induktive Erwärmung auf etwa 280°C für einen Zeitraum von 20 Sekunden führt zur Bildung der MgZn₂-Phase.

Unmittelbar anschließend läuft das Stahlband in die Aktivierungseinrichtung ein, in der eine Aktivierungslösung auf die zu phosphatierenden Bandoberflächen gesprüht wird. Als Aktivierungslösung werden dabei wässrige Dispersionen von Titanorthophosphaten auf Basis von Natriumphosphaten eingesetzt.

Das Aufbringen der Aktivierungslösung hat den Zweck, gezielt Kristallisationskeime an der Bandoberfläche zu vermehren. Auf diese Weise wird die Anzahl der Kristalle pro Flächeneinheit erhöht und dementsprechend die Kristallgröße sowie das Schichtgewicht reduziert. Darüber hinaus bewirken die Kristallisationskeime, dass bei der anschließend durchgeführten Phosphatierung kleine Zink(Magnesium)phosphatkristalle entstehen. Kleine Zink(Magnesium)phosphatkristalle erweisen sich wie oben dargelegt als günstig, weil sie unter anderem bei der Umformung des Stahlbands zu Bauteilen auch unter hohen wirksamen Umformkräften die Gefahr des Reißens der Phosphatschicht vermindern. Durch die feine Kristallstruktur wird die Ölaufnahme und -abgabe beim Abpressen erleichtert.

Nach dem Aktivieren tritt das Stahlband in die Phosphatspüleinrichtung ein. Darin sind Spüldüsen eingebaut, über die die Phosphatierlösung auf die zu beschichtenden Oberflächen des Stahlbands gespült wird. Als Phosphatierlösung kommt dabei eine zu diesem Zweck an sich unter dem Handelsnamen "Granodine 5854 E10" bekannte zum Einsatz. Diese Lösung ist nach dem "Trikation-System" zusammengesetzt und enthält neben Zinkionen auch Ni- und Mg-Ionen, um optimierte Gebrauchseigenschaften der auf die Bandoberflächen applizierten Phosphatschicht sicherzustellen.

Nach Verlassen der Phosphatiereinrichtung werden die beschichteten Bandoberflächen in der Passiviereinrichtung mit einer anorganischen, Titan- und Zirkon enthaltenden Lösung benetzt, um sie chemisch zu inaktivieren. Um eventuell auf den Bandoberflächen vorhandene Ablagerungen zu entfernen und deren Neubildung zu unterdrücken, werden die Bandoberflächen dann noch mit voll entsalztem Wasser gespült.

Anschließend durchläuft das Stahlband den Trockner. Diesen verlässt es mit trockenen Oberflächen.

Ein für die erfindungsgemäßen Zwecke geeignetes Verfahren zum Verzinken eines Stahlblechs und zum anschließenden Aufbringen einer Magnesiumschicht gefolgt von einer Wärmebehandlung ist beispielsweise in der DE 10 2005 045780 A beschrieben, auf deren Offenbarung hiermit ausdrücklich Bezug genommen wird.

### Ausführungsbeispiel 2

Die Zusammensetzung von Phosphatschichten verschiedener Auflagengewichte von gemäß Ausführungsbeispiel 1 hergestellten erfindungsgemäßen Stahlblechen wird mit herkömmlich elektrolytisch verzinkten und phosphatierten Stahlbändern verglichen.

Hierzu wird handelsübliches Stahlband in bekannter Weise gebeizt und elektrolytisch verzinkt und anschließend mit einer wässrigen Dispersion von Titanorthophosphonaten auf Basis von Natriumphosphaten als Aktivierungslösung aktiviert und mit Granodine 5854 E10 als Phophatierlösung spritzphosphatiert.

In Tabelle 1 sind Schichtzusammensetzungen der Phophatschichten verschiedener Schichtgewichte nach der Spritzphosphatierung der erfindungsgemäßen Stahlbleche (ZEMg) im Vergleich zu herkömmlichen elektrolytisch verzinkten Stahlblechen (ZE) angegeben.

**Tabelle 1: Schichtzusammensetzungen verschiedener Schichtgewichte nach Spritzphosphatierung**

| | **Phosphatschichtgewicht in mg/m²** | **% Ni** | **% Mn** | **% Mg** | **= mg Mg** |
|---|---|---|---|---|---|
| ZE | **1505** | 1,0 | 4,1 | **0,0** | |
| ZE | **1624** | 1,1 | 4,2 | **0,0** | |
| ZE | **1220** | 1,1 | 4,1 | **0,0** | |
| ZE | **1173** | 1,1 | 4,3 | **0,0** | |
| ZE | **867** | 1,1 | 4,1 | **0,0** | |
| ZE | **891** | 1,1 | 4,1 | **0,0** | |
| ZE | **289** | 1,3 | 4,3 | **0,0** | |
| ZE | **310** | 1,0 | 4,1 | **0,0** | |
| ZE | **579** | 1,1 | 4,0 | **0,0** | |
| ZE | **578** | 1,1 | 4,2 | **0,0** | |
| | | | | | |
| ZEMg | **886** | 1,5 | 4,7 | **1,4** | 12,4 |
| ZEMg | **577** | 1,3 | 5,1 | **1,4** | 8,1 |
| ZEMg | **455** | 1,2 | 4,7 | **2,5** | 11,4 |
| ZEMg | **166** | 1,9 | 5,6 | **5,7** | 9,5 |
| ZEMg | **143** | 1,3 | 5,2 | **7,6** | 10,9 |
| ZEMg | **1322** | 1,6 | 4,8 | **1,1** | 14,5 |
| ZEMg | **1177** | 1,4 | 5,1 | **0,8** | 9,4 |

Die Nickel- und Mangangehalte der erfindungsgemäß beschichteten Bleche liegen in einem für ZE typischen Bereich und sind unabhängig von der Phosphatauflage. Darüber hinaus zeigt sich, dass Magnesium nahezu unabhängig von der Phosphatauflage mit rund 9 bis 15 mg/m² eingebaut wird.

## Patentansprüche

1. Verfahren zum Herstellen eines Blechs aus Stahl für die Herstellung von Stahlbauteilen durch Umformen, insbesondere Tiefziehen, wobei das Blech mit einer Zink/Magnesiumschicht und einer auf dieser angeordneten Magnesium enthaltenden Phosphatschicht belegt ist, umfassend folgende Schritte:
- Aufbringen einer Zink/Magnesiumschicht auf das Stahlblech,
- Aufbringen einer Phosphatierlösung auf das mit der Zink/Magnesiumschicht versehene Stahlblech.

2. Verfahren nach Anspruch 1, **dadurch**
**gekennzeichnet, dass** das Aufbringen der Zink/Magnesiumschicht **dadurch** erfolgt, dass das Stahlblech zunächst verzinkt und anschließend mit einer Magnesiumschicht versehen wird.

3. Verfahren nach Anspruch 2, **dadurch**
**gekennzeichnet, dass** das Verzinken über Schmelztauchen, elektrolytisches Beschichten oder Aufdampfen erfolgt.

4. Verfahren nach Anspruch 2 oder 3, **dadurch**
**gekennzeichnet, dass** das Aufbringen der Magnesiumschicht über physikalische Dampfphasenabscheidung von Magnesium erfolgt.

5. Verfahren nach einem der Ansprüche 2 bis 4,
**dadurch gekennzeichnet, dass** die Zink/Magnesiumschicht auf Temperaturen von 200°C bis 500°C erwärmt wird.

6. Verfahren nach einem der Ansprüche 1 bis 5,
**dadurch gekennzeichnet, dass** die Zink/Magnesiumschicht auf das Stahlblech durch Schmelztauchen aufgebracht wird.

7. Verfahren nach einem der Ansprüche 1 bis 6,
**dadurch gekennzeichnet, dass** die Zink/Magnesiumschicht auf das Stahlblech durch elektrolytische Abscheidung, vorzugsweise aus aprotischen Lösungen, abgeschieden wird.

8. Verfahren nach einem der voranstehenden Ansprüche,
**dadurch gekennzeichnet, dass** die Phosphatierlösung im Tauch-, Spritz- oder Roll-coat-Verfahren auf das mit der Zink-Magnesium Schicht versehene Stahlblech aufgebracht wird.

9. Verfahren nach Anspruch 8, **dadurch**
**gekennzeichnet, dass** die eingesetzte Phosphatierlösung Magnesium, Nickel, Mangan und/oder Zink enthält.

10. Verfahren nach Anspruch 9, **dadurch**
**gekennzeichnet, dass** eine Phosphatierlösung mit einem Gehalt an Magnesium von weniger als 0,5 g/l und insbesondere weniger als 0,1 g/l, eingesetzt wird.

11. Verfahren nach Anspruch 9 oder 10, **dadurch**
**gekennzeichnet, dass** eine Phosphatierlösung mit einem Gehalt an Nickel von weniger als 0,05 g/l, vorzugsweise weniger als 0,015 g/l, eingesetzt wird.

12. Verfahren nach einem der Ansprüche 8 bis 11,
**dadurch gekennzeichnet, dass** eine Phosphatierlösung mit einem Gehalt an Mangan von 1 g/l bis 6 g/l, vorzugsweise von 1,5 g/l bis 4 g/l, eingesetzt wird.

13. Verfahren nach einem der Ansprüche 8 bis 12,
**dadurch gekennzeichnet, dass** eine Phosphatierlösung mit einem Gehalt an Zink von 1 g/l bis 7 g/l, vorzugsweise von 2 g/l bis 4,5 g/l, eingesetzt wird.

14. Stahlblech für die Herstellung von Bauteilen durch Umformen, insbesondere Tiefziehen, belegt mit einer Magnesium enthaltenden Phosphatschicht, **dadurch gekennzeichnet, dass** zwischen Stahlblech und Magnesium enthaltender Phosphatschicht eine Zink/Magnesiumschicht angeordnet ist.

15. Stahlblech nach Anspruch 14, **dadurch**
**gekennzeichnet, dass** die Magnesium enthaltende Phosphatschicht ein Schichtgewicht von 0,01 bis 3 g/m², vorzugsweise von 0,1 bis 1,8 g/m² und insbesondere von 0,7 bis 1 g/m² aufweist.

16. Stahlblech nach einem der Ansprüche 14 oder 15,
**dadurch gekennzeichnet, dass** die mittlere Kristallgröße der Phosphatschicht 0,1 bis 5 µm, vorzugsweise 0,5 bis 4 µm, insbesondere 1 bis 3 µm beträgt.

17. Stahlblech nach einem der Ansprüche 14 bis 16,
**dadurch gekennzeichnet, dass** der Magnesiumgehalt in der Phosphatschicht 0,1 bis 5 Gew.%, vorzugsweise 0,5 bis 3 Gew.%, beträgt.

18. Stahlblech nach einem der Ansprüche 14 bis 17,
**dadurch gekennzeichnet, dass** die Phosphatschicht Zink, Mangan und/oder Nickel enthält.

19. Stahlblech nach Anspruch 18, **dadurch**
**gekennzeichnet, dass** der Nickelgehalt in der Phosphatschicht weniger als 1,5 Gew.%, vorzugsweise weniger als 1 Gew.%, beträgt.

20. Stahlblech nach Anspruch 18 oder 19, **dadurch**
**gekennzeichnet, dass** der Mangangehalt in der Phosphatschicht 1 bis 8 Gew.%, vorzugsweise 3 bis 5 Gew.% beträgt.

21. Stahlblech nach einem der Ansprüche 18 bis 20,
**dadurch gekennzeichnet, dass** der Zinkgehalt in der Phosphatschicht in Summe mit den anderen Kationen 41-43 Gew% ergibt.

22. Stahlblech nach einem der Ansprüche 14 bis 21,
**dadurch gekennzeichnet, dass** die Zink/Magnesiumschicht und/oder die darauf angeordnete Magnesium enthaltende Phosphatschicht auf der Ober- und Unterseite des Blechs aufgebracht ist.
